# EUROPÄISCHE PATENTSCHRIFT

(11) **EP 4 065 994 B1**
(45) Veröffentlichungstag und Bekanntmachung des Hinweises auf die Patenterteilung: **04.09.2024**
(21) Anmeldenummer: 20785497.7
(22) Anmeldetag: 30.09.2020
(51) Int. Cl.: G01R 31/392, G01R 31/371, G01R 31/396, H02J 7/00, H01M 10/48, H01M 10/42

(54) **BATTERIEDIAGNOSE FÜR EIN ELEKTRISCH BETRIEBENES FAHRZEUG**
BATTERY DIAGNOSIS FOR AN ELECTRICALLY DRIVEN VEHICLE
DIAGNOSTIC DE BATTERIE POUR UN VÉHICULE À PROPULSION ÉLECTRIQUE

(30) Priorität: 27.11.2019 DE 102019218333
(43) Veröffentlichungstag der Anmeldung: 05.10.2022
(73) Patentinhaber: Robert Bosch GmbH, 70442 Stuttgart (DE)
(72) Erfinder: EITEL, Peter, 73730 Esslingen (DE); SCHLASZA, Christian, 73728 Esslingen (DE)
(86) Internationale Anmeldenummer: PCT/EP2020/077374
(87) Internationale Veröffentlichungsnummer: WO 2021/104721

(56) Entgegenhaltungen:
- EP-B1- 2 589 103
- DE-A1- 102009 027 595
- DE-A1- 102011 083 150

## Beschreibung

Die Erfindung betrifft ein Diagnosetestgerät und einen Diagnoseplatz für ein elektrisch betriebenes Fahrzeug ("Elektrofahrzeug"). Die Erfindung betrifft auch Verfahren zum Testen und Reparieren einer in einem elektrisch betriebenen Fahrzeug verbauten elektrischen Batterie.

### Stand der Technik

Die Verwendbarkeit batteriebetriebener Elektrofahrzeuge wird in erheblichem Ausmaß durch den Gesundheitszustand ("State of Health", SOH) der im Fahrzeug verbauten elektrischen Batterie bestimmt.

Die elektrischen Batterien von Elektrofahrzeugen sind üblicherweise modular, d.h. aus mehreren Modulen, aufgebaut. Jedes Modul besteht aus Zellen, die in der Regel nicht einzeln ersetzt werden können. Somit ist ein Modul die kleinste austauschbare Einheit der Batterie. Die schwächste Zelle eines Moduls limitiert den Gesundheitszustand des Moduls, das schwächste Modul limitiert den Gesundheitszustand der Batterie.

Durch eine mit einem Batterie-Diagnosetester durchgeführte Diagnose kann der Gesundheitszustand der Batterie bzw. der Module der Batterie bestimmt werden. Ergibt die Diagnose, dass wenigstens eines der Module ausgetauscht werden muss, ist der Ladezustand des neu einzubauenden Moduls bzw. der neu einzubauenden Module an den Ladezustand der in der Batterie verbleibenden Module anzugleichen. Nach dem Austausch wenigstens eines der Module müssen Abschlusstests (sogenannte "End of Service"/EOS-Tests) durchgeführt werden, bevor das Fahrzeug wieder an den Kunden übergeben werden kann. Vor der Übergabe des Elektrofahrzeugs an den Kunden wird der Ladezustand der Batterie ggf. mit Hilfe einer Ladestation erhöht, um dem Kunden das Fahrzeug mit einer ausreichenden Reichweite zu übergeben.

Für die Diagnose und Reparatur einer elektrischen Batterie eines Elektrofahrzeugs sind bisher mehrere verschiedene Geräte erforderlich. Dies macht die Reparatur von Elektrofahrzeugen aufwändig und teuer. Relevanter Stand der Technik findet sich in den Dokumenten EP2589103B1 , DE102009027595A1 und DE102011083150A1.

### Offenbarung der Erfindung:

Es ist eine Aufgabe der Erfindung, die Reparatur von Elektrofahrzeugen, insbesondere das Überprüfen und ggf. Reparieren der Batterie eines Elektrofahrzeugs, zu vereinfachen und kostengünstiger zu gestalten. Die vorliegende Erfindung löst die oben genannte Aufgabe durch eine Vorrichtung nach Anspruch 1 und ein entsprechendes Verfahren nach Anspruch 10. Weitere Ausführungsformen sind in den abhängigen Ansprüchen definiert. Zusätzliche nicht beanspruchte Ausführungsformen, Aspekte oder Beispiele werden zum besseren Verständnis der Erfindung auch in der Beschreibung dargestellt.

Ein Ausführungsbeispiel der Erfindung umfasst ein Diagnosetestgerät zum Bestimmen eines Gesundheitszustands ("SOH") einer elektrischen Batterie eines Elektrofahrzeugs. Das Diagnosetestgerät ist sowohl mit einer Steuerelektronik des Elektrofahrzeugs als auch mit einer elektrischen Lade-/Entladevorrichtung verbindbar. Das Diagnosetestgerät ist ausgebildet, die elektrische Lade-/Entladevorrichtung derart anzusteuern, dass die Lade-/Entladevorrichtung die im Fahrzeug verbaute elektrische Batterie in wenigstens einem vorgegebenen Ladevorgang lädt und/oder die im Fahrzeug verbaute elektrische Batterie in wenigstens einem vorgegebenen Entladevorgang entlädt und wenigstens einen vorgegebenen Stromimpuls auf die im Fahrzeug verbaute elektrische Batterie aufbringt. Das Diagnosetestgerät ist darüber hinaus ausgebildet, von der Steuerelektronik des Fahrzeugs auf die Batterie bezogene Daten zu empfangen und die von der Steuerelektronik des Fahrzeugs empfangenen Daten auszuwerten, um den Gesundheitszustand der Batterie zu bestimmen.

Ausführungsbeispiele der Erfindung umfassen auch einen Diagnoseplatz für ein Elektrofahrzeug mit einer elektrischen Batterie, wobei der Diagnoseplatz ein Diagnosetestgerät gemäß einem Ausführungsbeispiel der Erfindung und eine elektrische Lade-/Entladevorrichtung aufweist, die von dem Diagnosetestgerät ansteuerbar ist.

Ausführungsbeispiele der Erfindung umfassen darüber hinaus ein Verfahren zum Bestimmen eines Gesundheitszustands einer in einem Elektrofahrzeug verbauten elektrischen Batterie. Das Verfahren umfasst, das Elektrofahrzeug mit einer elektrischen Lade-/Entladevorrichtung und mit einem Diagnosetestgerät zu verbinden; die elektrische Lade-/Entladevorrichtung mit dem Diagnosetestgerät derart anzusteuern, dass die Lade-/Entladevorrichtung die im Fahrzeug verbaute elektrische Batterie in wenigstens einem vorgegebenen Ladevorgang lädt und/oder die elektrische Batterie in wenigstens einem vorgegebenen Entladevorgang entlädt und wenigstens einen vorgegebenen Stromimpuls auf die elektrische Batterie aufbringt, während die Batterie im Fahrzeug verbaut ist. Das Verfahren umfasst darüber hinaus, während des wenigstens einen Lade- und/oder Entladevorgangs bzw. vor, während und/oder nach dem wenigstens einen Stromimpuls auf die Batterie bezogene Daten (Messwerte) aufzunehmen und die Daten auszuwerten, um den Gesundheitszustand der Batterie zu bestimmen.

Ausführungsbeispiele der Erfindung umfassen auch ein Verfahren zum Reparieren einer in einem Elektrofahrzeug verbauten elektrischen Batterie, wobei das Verfahren umfasst, die elektrische Batterie aus dem Fahrzeug auszubauen, die elektrische Batterie zu reparieren, die elektrische Batterie wieder in das Fahrzeug einzubauen und den Gesundheitszustand der wieder in das Fahrzeug eingebauten Batterie mit einem Verfahren gemäß einem Ausführungsbeispiel der Erfindung zu bestimmen. Das Reparieren der elektrischen Batterie kann insbesondere umfassen, wenigstens ein defektes Modul der elektrischen Batterie oder wenigstens einen elektrischen Modulverbinder auszutauschen. Ausführungsbeispiel der Erfindung ermöglichen es, eine Leistungselektronik einer elektrischen Lade-/Entladevorrichtung, welche in der Lage ist, die beim Laden und Entladen einer Fahrzeug-Batterie auftretenden starken Ströme zu verarbeiten, zur Batteriediagnose zu nutzen. Auf diese Weise kann die Leistungselektronik einer ggf. bereits vorhandenen Lade-/Entladevorrichtung auch zu Diagnosezwecken genutzt werden. Auf das Bereitstellen einer zusätzlichen, teuren Leistungselektronik kann daher verzichtet werden.

Eine erfindungsgemäße Batteriediagnose kann mit einer elektrischen Lade-/Entladevorrichtung in Verbindung mit einem einzigen Diagnosetestgerät durchgeführt werden.

Anders als aus dem Stand der Technik bekannt, müssen für die Reparatur eines Elektrofahrzeugs in der Werkstatt nicht mehrere verschiedene Geräte vorgehalten und eingesetzt werden, um die Batterie eines elektrisch betriebenen Fahrzeugs überprüfen und ggf. reparieren zu können.

Die Reparatur von Elektrofahrzeugen wird auf diese Weise vereinfacht und die in der Werkstatt anfallenden Kosten können deutlich reduziert werden.

In einer Ausführungsform umfassen die auf die Batterie bezogenen Daten ein Belastungsprofil der Batterie. Das Auswerten eines Belastungsprofils der Batterie ermöglicht eine zuverlässige Batteriediagnose.

In einer Ausführungsform ist das Diagnosetestgerät ausgebildet, unterschiedliche Ladezustände verschiedener Module der Batterie zu erkennen und die elektrische Lade-/Entladevorrichtung derart anzusteuern, dass unterschiedliche Ladezustände verschiedener Module der Batterie durch die elektrische Lade-/Entladevorrichtung ausgeglichen werden. Insbesondere kann der Ladezustand eines Ersatzmoduls, das in die Batterie eingebaut werden soll, um ein defektes Modul zu ersetzen, an die Ladezustände der anderen, in der Batterie verbleibenden, Module angepasst werden, so dass alle Module der Batterie im Wesentlichen den gleichen Ladezustand haben.

In einer Ausführungsform ist das Diagnosetestgerät dazu ausgebildet, den Gesundheitszustand der Batterie nach einer Reparatur, insbesondere nach einem Austausch wenigstens eines Moduls oder eines Modulverbinders der Batterie, zu bestimmen. Auf diese Weise kann zuverlässig überprüft werden, ob die Reparatur erfolgreich war, oder ob weitere Diagnose- und/oder Reparaturschritte durchgeführt werden müssen, bevor die Batterie und das Fahrzeug an den Kunden zurückgegeben werden können.

In einer Ausführungsform ist das Diagnosetestgerät dazu ausgebildet, den Gesundheitszustand der Batterie vor einer Reparatur zu bestimmen. Das Diagnosetestgerät kann insbesondere dazu ausgebildet sein, den Gesundheitszustand einzelner Module der Batterie zu bestimmen, so dass einzelne defekte Module gezielt erkannt und ausgetauscht werden können.

In einer Ausführungsform ist das Diagnosetestgerät dazu ausgebildet, die elektrische Lade-/Entladevorrichtung derart anzusteuern, dass die elektrische Lade-/Entladevorrichtung Tests an einer Batterie vornimmt, die aus dem Fahrzeug ausgebaut und separat mit der Lade-/Entladevorrichtung verbunden ist. Diese Tests können insbesondere umfassen, die elektrische Isolation der Batterie und/oder die Niederohmigkeit der elektrischen Verbindungen mit und innerhalb der Batterie zu überprüfen. Auf diese Weise kann das Risiko reduziert werden, dass eine defekte und/oder nicht vollständig reparierte Batterie in das Fahrzeug eingebaut wird.

In einer Ausführungsform ist das Diagnosetestgerät dazu ausgebildet, drahtgebunden oder drahtlos mit einer Steuerelektronik des Fahrzeugs zu kommunizieren. Eine drahtgebundene Kommunikation, beispielsweise über eine OBD/OBD2-Schnittstelle (Steckverbindung) des Fahrzeugs ist zuverlässig und kann besonders einfach und kostengünstig realisiert werden. Eine drahtlose Kommunikation, beispielsweise über eine WLAN- oder Bluetooth^{®}- oder Mobilfunk-Verbindung, ermöglicht eine besonders einfache und bequeme Handhabung des Diagnosetestgeräts, da in diesem Fall auf das Herstellen einer drahtgebundenen Verbindung zwischen dem Fahrzeug und dem Diagnosetestgerät verzichtet werden kann und das Diagnosetestgerät frei beweglich ist.

In einer Ausführungsform ist die elektrische Lade-/Entladevorrichtung auch dazu ausgebildet, wahlweise elektrische Energie aus der Batterie in ein elektrisches Versorgungsnetz einzuspeisen. Die Batterie des Fahrzeugs kann auf diese Weise als Energiespeicher und -puffer verwendet werden, um schwankende Belastungen des Versorgungsnetzes auszugleichen.

In einer Ausführungsform ist zwischen der Lade-/Entladevorrichtung und dem elektrischen Versorgungsnetz eine elektrische Speichervorrichtung (Energiepuffer) vorgesehen, um die von der Lade-/Entladevorrichtung verursachte elektrische Belastung des elektrischen Versorgungsnetzes abzupuffern, die durch starke elektrische Ströme verursacht wird, wie sie beim Laden und Entladen der Batterie auftreten.

In einer Ausführungsform ist das Diagnosetestgerät dazu ausgebildet, eine stationäre elektrische Ladestation so anzusteuern, dass die stationäre elektrische Ladestation als erfindungsgemäße Lade-/Entladevorrichtung zum Einsatz kommt. Auf diese Weise kann die Leistungselektronik einer bereits vorhandenen stationären Ladestation auch zu Diagnosezwecken genutzt werden. Auf das Bereitstellen einer zusätzlichen Leistungselektronik, welche in der Lage ist, die beim Laden und Entladen der Batterie fließenden hohen Ströme zu verarbeiten, kann in diesem Fall verzichtet werden. Die Kosten eines Diagnoseplatzes für Elektrofahrzeuge können auf diese Weise deutlich gesenkt werden.

Ein Ausführungsbeispiel der Erfindung wird im Folgenden unter Bezugnahme auf die beigefügten Figuren beschrieben.

### Kurze Beschreibung der Figuren

Figur 1 zeigt in einer schematischen Darstellung einen Diagnoseplatz zur Diagnose der Batterie eines elektrisch betriebenen Fahrzeugs.
Figur 2 zeigt eine vergrößerte schematische Darstellung eines Diagnosetestgeräts, das gemäß einem Ausführungsbeispiel der Erfindung ausgebildet ist.

### Figurenbeschreibung

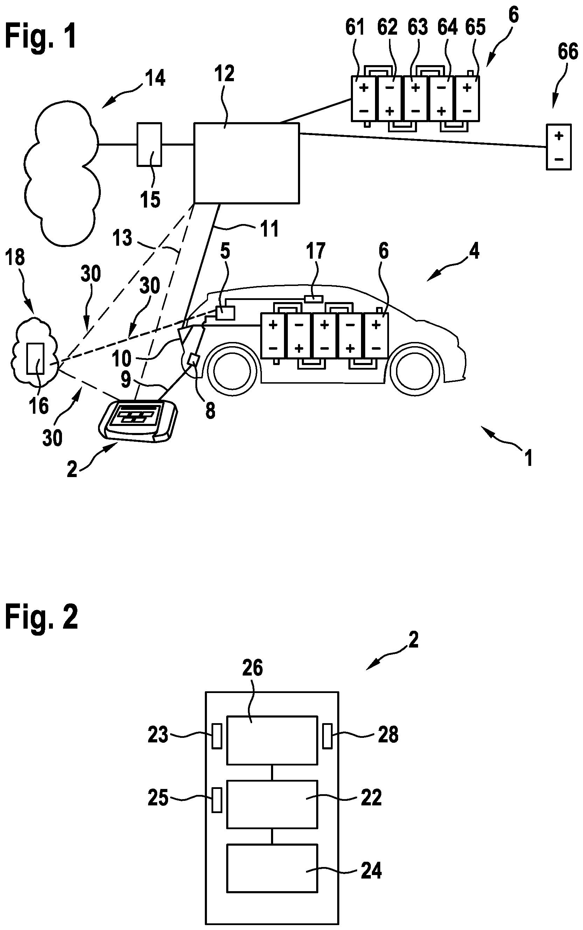

Figur 1 zeigt in einer schematischen Darstellung einen Diagnoseplatz 1 zur Diagnose eines elektrisch betriebenen Fahrzeugs ("Elektrofahrzeug") 4, das von einer in dem Fahrzeug 4 angeordneten elektrischen Batterie 6 mit elektrischer Energie versorgt wird.

Bei dem elektrisch betriebenen Fahrzeug 4 kann es sich um ein reines Elektrofahrzeug 4 handeln, d.h. um ein Fahrzeug 4, das ausschließlich elektrisch angetrieben wird. Bei dem elektrisch betriebenen Fahrzeug 4 kann es sich aber auch um ein Plug-in-Hybrid-Fahrzeug 4 handeln, das zusätzlich zu einem Elektromotor einen Verbrennungsmotor aufweist. Der Verbrennungsmotor kann dazu ausgebildet sein, das Fahrzeug 4 über eine Kupplung und ein Getriebe mechanisch anzutreiben. Alternativ oder zusätzlich kann der Verbrennungsmotor dazu vorgesehen sein, einen Generator anzutreiben, um die elektrische Batterie 6 des Fahrzeugs 4 zu laden.

Die elektrische Batterie 6 ist beispielsweise eine Hochvolt-Batterie ("HV-Batterie") 6 mit einer Betriebsspannung U_{Batt} von wenigstens 60 V.

Die elektrische Batterie 6 umfasst mehrere elektrische Module 61-65, die durch elektrische Modulverbinder 7 elektrisch miteinander verbunden sind. Die Module 61-65 sind beispielsweise in einer elektrischen Reihenschaltung miteinander verbunden, so dass sich die Spannungen der einzelnen Module 61-65 addieren.

Das Fahrzeug 4 weist eine Diagnoseschnittstelle 8 und eine Ladeschnittstelle 10 auf.

Über die Ladeschnittstelle 10 ist die elektrische Batterie 6 des Fahrzeugs 4 mit Hilfe eines Ladekabels 11 mit einer elektrischen Lade-/Entladevorrichtung 12 verbindbar, die dazu ausgebildet ist, die Batterie 6 zu laden und/oder zu entladen.

Die Lade-/Entladevorrichtung 12 ist elektrisch mit einem elektrischen Versorgungsnetz ("Stromnetz") 14 verbunden. Die Lade-/Entladevorrichtung 12 kann insbesondere als bidirektionale Lade-/Entladevorrichtung 12 ("Vehicle to Grid"/"V2G"-Ladestation) ausgebildet sein.

Eine bidirektionale Lade-/Entladevorrichtung 12 ermöglicht es nicht nur, elektrische Energie aus dem elektrischen Versorgungsnetz 14 zu entnehmen und die Batterie 6 des Fahrzeugs 4 mit dieser elektrischen Energie zu laden; eine bidirektionale Lade-/Entladevorrichtung 12 ermöglicht es auch, elektrische Energie aus der Batterie 6 zu entnehmen und in das elektrische Versorgungsnetz 14 abzugeben; beispielsweise, um die Batterie 6 kontrolliert zu entladen.

Darüber hinaus ermöglicht es eine bidirektionale Lade-/Entladevorrichtung 12, das elektrische Versorgungsnetz 14 mit Energie aus der Batterie 6 zu stabilisieren, wenn das Fahrzeug 4 nicht benutzt wird, so dass die in der Batterie 6 des Fahrzeugs 4 gespeicherte Energie vom Fahrzeug 4 nicht benötigt wird und dem elektrischen Versorgungsnetz 14 bei Bedarf zur Verfügung gestellt werden kann.

Zwischen der Lade-/Entladevorrichtung 12 und dem elektrischen Versorgungsnetz 14 kann ein Energiespeicher bzw. -puffer 15 vorgesehen sein, um eine von der Lade-/Entladevorrichtung 12 verursachte elektrische Belastung des elektrischen Versorgungsnetzes 14, die durch die beim Laden und Entladen der Batterie 6 fließenden starken elektrischen Ströme verursacht wird, abzupuffern.

Figur 1 zeigt darüber hinaus ein Diagnosetestgerät 2, das gemäß einem Ausführungsbeispiel der Erfindung ausgebildet ist.

Figur 2 zeigt eine vergrößerte schematische Darstellung des Diagnosetestgeräts 2.

Das Diagnosetestgerät 2 verfügt über eine Recheneinheit 22, beispielsweise einen Mikroprozessor, auf dem ein geeignetes Programm abläuft, oder einen ASIC, der dazu ausgebildet ist, die im Folgenden im Detail beschriebenen Funktionen des Diagnosetestgeräts 2 bereitzustellen.

Das Diagnosetestgerät 2 weist eine Eingabevorrichtung 24, beispielsweise eine Tastatur, und eine Ausgabevorrichtung 26, beispielsweise einen Bildschirm auf. Die Eingabevorrichtung 24 und die Ausgabevorrichtung 26 können auch zu einer gemeinsamen Ein- und Ausgabevorrichtung 24, 26, beispielsweise in Form eines berührungsempfindlichen Bildschirms ("Touchscreen"), zusammengefasst sein.

Das Diagnosetestgerät 2 ist darüber hinaus mit wenigstens zwei Schnittstellen 23, 28 ausgestattet, die es dem Diagnosetestgerät 2 ermöglichen, mit einer Steuerelektronik 5 des Fahrzeugs 4 und der Lade-/Entladevorrichtung 12 zu kommunizieren.

Eine Fahrzeug-Schnittstelle 28 des Diagnosetestgeräts 2 ist insbesondere über eine am Fahrzeug 4 vorhandene Diagnoseschnittstelle 8, z.B. eine OBD- oder OBD2-Schnittstelle derart mit einer Steuerelektronik 5 des Fahrzeugs 4 verbindbar, dass das Diagnosetestgerät 2 mit der Steuerelektronik 5 des Fahrzeugs 4 kommunizieren kann.

Die Verbindung zwischen dem Diagnosetestgerät 2 und der Steuerelektronik 5 des Fahrzeugs 4 kann drahtgebunden, d.h. über eine Kabelverbindung 9, oder drahtlos, beispielsweise über eine (in der Figur 1 nicht gezeigte) WLAN-, Bluetooth^{®}- oder Mobilfunkverbindung, herstellbar sein.

Eine weitere Schnittstelle ("Lade-/Entladevorrichtungsschnittstelle") 23 des Diagnosetestgeräts 2 ist dazu ausgebildet, über eine Steuerverbindung 13, die ebenfalls drahtgebunden oder drahtlos ausgebildet sein kann, mit der Lade-/Entladevorrichtung 12 zu kommunizieren. Die Lade-/Entladevorrichtung 12 ist insbesondere über die Steuerverbindung 13 von dem Diagnosetestgerät 2 ansteuerbar.

Optional kann das Diagnosetestgerät 2 eine dritte Schnittstelle ("Kommunikationsschnittstelle") 25 aufweisen, die es dem Diagnosetestgerät 2 ermöglicht, mit einem außerhalb des Diagnoseplatzes 1 angeordneten Server 16 zu kommunizieren. Die Steuerelektronik 5 des Fahrzeugs 4 und/oder die Lade-/Entladevorrichtung 12 können ebenfalls zur Kommunikation mit dem Server 16 ausgebildet sein. Die Kommunikation mit dem Server 16 kann über das Internet 30 und/oder über ein Mobilfunknetz 30 erfolgen. Der Server 16 kann Teil einer virtuellen Cloud 18 sein.

Wenn das Diagnosetestgerät 2 zur Kommunikation mit einem Server 16 ausgebildet ist, kann das Diagnosetestgerät 2 statt über direkte Verbindungen 9 und 13 auch über den Server 16 mit der Steuerelektronik 5 des Fahrzeugs 4 und/oder mit der Lade-/Entladevorrichtung 12 kommunizieren. Das Diagnosetestgerät 2 kann insbesondere dazu ausgebildet sein, ausschließlich über den Server 16 mit der Steuerelektronik 5 des Fahrzeugs 4 und der Lade-/Entladevorrichtung 12 zu kommunizieren. Auf Schnittstellen 23, 28, die eine direkte Kommunikation des Diagnosetestgeräts 2 mit der Steuerelektronik 5 des Fahrzeugs 4 bzw. der Lade-/Entladevorrichtung 12 ermöglichen, kann in diesem Fall verzichtet werden.

Ein erfindungsgemäßes Diagnosetestgerät 2 ist dazu ausgebildet, Funktionen zur Diagnose und ggf. Reparatur der im Fahrzeug 4 verbauten Batterie 6 zur Verfügung zu stellen.

Das Diagnosetestgerät 2 stellt insbesondere wenigstens eine Testfunktion zur Verfügung, die es ermöglicht, die Batterie 6 zu testen, während die Batterie 6 im Fahrzeug 4 eingebaut ist.

Dazu liest das Diagnosetestgerät 2 beispielsweise Diagnosedaten aus der Steuerelektronik 5 aus, die während des Betriebs des Fahrzeugs 4 erfasst worden sind, und wertet diese Diagnosedaten aus. Die Diagnosedaten können beispielsweise Fehler(speicher)einträge, Temperatureinträge, die Verteilung der Zellspannungen der Batterie 6, das Alter der Batterie 6, bzw. der einzelnen Module 61-65, und ähnliche Informationen umfassen.

In Abhängigkeit vom Ergebnis dieser ersten Diagnose können weitere Diagnoseschritte (Tests) beispielsweise umfassen, durch gezielte Lade- und Entladevorgänge und/oder uni- oder bidirektionale Hochstromimpulse physikalische Reize auf die Batterie 6 auszuüben und die Reaktionen der Batterie 6, beispielsweise Spannungs- und/oder Temperaturschwankungen der Batterie 6, auf die physikalischen Reize mit Sensoren 17 zu messen.

Die Tests können auch umfassen, die Fähigkeit der Batterie 6, Energie zu speichern ("SOHc"), und/oder die Hochstromfähigkeit der Batterie 6 ("SOHr") zu überprüfen.

Die im Zuge der Tests gemessenen Parameter können mit spezifischen Referenzparametern, die für die jeweilige Batterie 6 vorgegeben sind, verglichen werden. Über die Kommunikationsschnittstelle 25 kann auch überprüft werden, welche Ersatzteile aktuell in der Werkstatt und/oder am Markt verfügbar sind; beispielsweise um zu entscheiden, ob einzelne Module 61-65 der Batterie 6 verfügbar sind und einzeln ausgetauscht werden können.

Führen die auf diese Weise durchgeführten Tests zu dem Ergebnis, dass die Batterie 6 fehlerhaft ist und beispielsweise wenigstens eines der Module 61-65 und/oder einer der Modulverbinder 7 ausgetauscht werden muss, wird die Batterie 6 aus dem Fahrzeug 4 ausgebaut, um die fehlerhaften Module 61-65 und/oder Modulverbinder 7 zu ersetzen.

Um die optimale Leistungsfähigkeit und eine lange Lebensdauer der Batterie 6 zu erreichen, sollten die Module 61-65 der Batterie 6 im Betrieb im Wesentlichen den gleichen Ladezustand haben. Daher muss beim Austausch wenigstens eines der Module 61-65 die elektrische Ladung des neu einzubauenden Moduls 66 an den Ladezustand der anderen Module 61-65 angepasst werden.

Dazu wird jedes neu in den Verbund der Module 61-65 einzusetzende Modul ("Ersatzmodul") 66 noch vor dem Einbau mit der Lade-/Entladevorrichtung 12 verbunden, und die Lade-/Entladevorrichtung 12 wird von dem Diagnosetestgerät 2 derart angesteuert, dass sie das Ersatzmodul 66 so lädt bzw. entlädt, dass die elektrische Ladung in dem neu einzusetzenden Modul 66 an den Ladezustand der in der Batterie 6 verbleibenden Module 61-65 angepasst wird.

Bei Bedarf können auch die in der Batterie 6 verbleibende Module 61-65 mit der Lade-/Entladevorrichtung 12 verbunden werden, um ihren Ladezustand anzupassen.

Nachdem die elektrische Ladung aller Module 61-66 auf einen gemeinsamen Wert eingestellt worden und das neue Modul 66 und/oder der neue Modulverbinder 7 in die Batterie 6 eingebaut worden ist, wird die Batterie 6 noch vor dem Einbau in das Fahrzeug 4 ersten Abschlusstests (sogenannten "EOS1-Tests") unterzogen, um zu vermeiden, dass eine defekte und/oder nicht vollständig funktionsfähige Batterie 6 in das Fahrzeug 4 eingebaut wird.

Die EOS1-Tests umfassen insbesondere, die elektrische Isolation der Batterie 6 und/oder die Niederohmigkeit der elektrischen Verbindungen mit und innerhalb der Batterie 6 zu überprüfen.

Ein erfindungsgemäßes Diagnosetestgerät 2 ist dazu ausgebildet, die EOS1-Tests im Zusammenwirken mit der elektrischen Lade-/Entladevorrichtung 12 durchzuführen, zu überwachen und auszuwerten. Um zu vermeiden, dass eine defekte und/oder nicht voll leistungsfähige Batterie 6 in das Fahrzeug 4 eingebaut wird, kann ein erfindungsgemäßes Diagnosetestgerät 2 dazu ausgebildet sein, ein optisches und/oder ein akustisches Warnsignal auszugeben, wenn bei wenigstens einem der EOS1-Tests ein Problem festgestellt wird.

Hat die Batterie 6 alle EOS1-Tests bestanden, wird die Batterie 6 in das Fahrzeug 4 eingebaut. Die Steuerelektronik 5 des Fahrzeugs 4 wird durch das Diagnosetestgerät 2 in einen Ausgangszustand zurückgesetzt ("reset") und von dem Diagnosetestgerät 2 mit neuen Parametern versorgt, die an den aktuellen Lade- und Gesundheitszustand der neu eingebauten Batterie 6 angepasst sind.

Danach wird wenigstens ein zweiter Abschlusstest ("EOS2-Test") durchgeführt. Auch der wenigstens eine zweite Abschlusstest ("EOS2-Test") wird durch Zusammenwirken des erfindungsgemäß ausgebildeten Diagnosetestgeräts 2 mit der elektrischen Lade-/Entladevorrichtung 12 durchgeführt. Die zweiten Abschlusstests umfassen insbesondere, die elektrischen Lade-/Entladevorrichtung 12 durch das Diagnosetestgerät 2 so anzusteuern, dass vorgegebenen Lade- und/oder Entladevorgänge der Batterie 6 durchgeführt werden und/oder die Batterie 6 definierten Stromimpulsen ausgesetzt wird.

Die Steuerelektronik 5 des Fahrzeugs 4 wird von dem Diagnosetestgerät 2 so angesteuert, dass über die Steuerelektronik 5 und im Fahrzeug 4 verbaute Sensoren 17 Parameter der Batterie 6 gemessen und ausgewertet werden, um mögliche Schwächen der Batterie 6, insbesondere Schwächen unter elektrischer Belastung, zu erkennen. Auf diese Weise können gegebenenfalls vorhandene Defekte und Schwächen der Batterie 6 erkannt und behoben werden, bevor das Fahrzeug 4 an den Kunden ausgeliefert wird.

Da die Batterie 6 während der zweiten Abschlusstests bereits (wieder) mit dem Fahrzeug 4 verbunden ist, ist es anders als bei herkömmlichen Tests, wie sie aus dem Stand der Technik bekannt sind, die an einer vom Fahrzeug 4 elektrisch getrennten Batterie 6 durchgeführt werden, nicht erforderlich, das elektrische Verhalten des Fahrzeugs 4 zu simulieren. Die Batterie 6 wird vielmehr in ihrer realen Umgebung im Fahrzeug 4 getestet. Dies ermöglicht genaue und zuverlässige Testergebnisse ohne das Verhalten des Fahrzeugs 4 zu simulieren.

Hat die Batterie 6 auch den wenigstens einen EOS2-Test bestanden, kann die im Fahrzeug 4 verbaute Batterie 6 durch die Lade-/Entladevorrichtung 12 auf einen gewünschten Ladezustand aufgeladen werden, bevor das Fahrzeug 4 an den Kunden übergeben wird. Auch dieser Ladevorgang kann über die Steuerverbindung 13 von dem Diagnosetestgerät 2 gestartet, gesteuert und überwacht werden.

Die Algorithmen zum Durchführen der zuvor beschriebenen Tests können auf dem Diagnosetestgerät 2 selbst, insbesondere auf einer in dem Diagnosetestgerät 2 vorhandenen Recheneinheit 22, z.B. einem Mikroprozessor und/oder einem ASIC, ablaufen.

Alternativ oder zusätzlich kann das Diagnosetestgerät 2 über die Kommunikationsschnittstelle 25 und z.B. über das Internet 30 oder über ein Mobilfunknetz 30, mit einem Server 16 verbunden sein, der räumlich von dem Diagnoseplatz 1 getrennt ist. Die Algorithmen können dann vollständig oder teilweise auf dem Server 16 ablaufen. Der Server 16 kann Teil einer virtuellen Cloud 18 sein.

Werden die Algorithmen auf einem von dem Diagnosetestgerät 2 getrennten Server 16 ausgeführt, muss das Diagnosetestgerät 2 keine leistungsfähige Hardware aufweisen, die geeignet ist, die notwendigen Algorithmen mit der erforderlichen Geschwindigkeit auszuführen. Das Diagnosetestgerät 2 kann vielmehr mit einfacher Hardware ausgestattet sein, welche die Kommunikation mit dem Server 16 ermöglicht. Das Diagnosetestgerät 2 kann daher kostengünstiger produziert werden als ein Diagnosetestgerät 2, das die Algorithmen selbst ausführt.

Ein erfindungsgemäßes Diagnosetestgerät 2 ermöglicht es, die mit dem Testen und ggf. notwendigen Austauschen der Batterie 6 eines elektrisch betriebenen Fahrzeugs 4 verbundenen Arbeitsschritte mit einem einzigen Diagnosetestgerät 2 und einer ggf. bereits vorhandenen elektrischen Lade-/Entladevorrichtung 12 durchzuführen.

Anders als aus dem Stand der Technik bekannt, müssen in der Werkstatt nicht mehrere verschiedene (Test-)Geräte vorgehalten und eingesetzt werden, um die Batterie 6 eines elektrisch betriebenen Fahrzeugs 4 testen und ggf. reparieren zu können, damit das Fahrzeug 4 wieder in einen betriebsfähigen Zustand gebracht werden kann.

Ein erfindungsgemäßes Diagnosetestgerät 2 kann insbesondere in einen herkömmlichen Diagnosetester, wie er in Werkstätten zur Fehlerdiagnose eingesetzt wird, integriert werden. Dadurch kann die Anzahl der in einer Werkstatt benötigten Geräte noch weiter reduziert werden.

Durch die Erfindung können die Arbeitsabläufe in der Werkstatt vereinfacht und beschleunigt werden. Auch die Kosten für das Überprüfen und ggf. notwendige Reparieren der Batterie 6 eines elektrisch betriebenen Fahrzeugs 4 können reduziert werden.

Als Lade-/Entladevorrichtung 12 kann eine herkömmliche Lade-/Entladevorrichtung 12 zum Einsatz kommen, sofern sie so ausgebildet ist, dass sie den Aufbau einer Steuerverbindung 13 mit dem Diagnosetestgerät 2 ermöglicht. Dies kann ggf. durch Aktualisieren der Software einer bereits vorhandenen Lade-/Entladevorrichtung 12 erreicht werden.

Ein Grundgedanke der Erfindung ist es, eine (ggf. bereits vorhandene) elektrische Lade-/Entladevorrichtung 12 zu nutzen, um die nach dem Reparieren der Batterie 6 notwendigen Abschlusstests ("EOS2-Tests") durchzuführen.

Auf das Bereitstellen eine zusätzlichen, teuren Leistungselektronik, welche geeignet ist, die beim Laden und Entladen der Batterie 6 üblicherweise fließenden großen Ströme zu übertragen und zu regeln, kann in diesem Fall verzichtet werden. Dadurch können die Kosten gesenkt werden.

Die zuvor beschriebenen Schritte des Testens der Batterie 6 vor dem Ausbau aus dem Fahrzeug 4, des Angleichens der Ladezustände der einzelnen Module 61-66 der Batterie 6 und des Durchführens von EOS1-Tests mit einem erfindungsgemäßen Diagnosetestgerät 2 sind optional und können ggf. weggelassen oder mit anderen Geräten durchgeführt werden, ohne den Schutzbereich der folgenden Patentansprüche zu verlassen.

## Patentansprüche

1. Diagnosetestgerät (2) zum Bestimmen eines Gesundheitszustands einer elektrischen Batterie (6) eines elektrisch betriebenen Fahrzeugs (4),
wobei das Diagnosetestgerät (2) eine Eingabevorrichtung (24) und eine Ausgabevorrichtung (26) aufweist und sowohl mit einer Steuerelektronik (5) des Fahrzeugs (4) als auch mit einer elektrischen Lade-/Entladevorrichtung (12) verbindbar ist, und
wobei das Diagnosetestgerät (2) ausgebildet ist,
die Lade-/Entladevorrichtung (12) derart anzusteuern, dass die Lade-/Entladevorrichtung (12) die elektrische Batterie (6) in wenigstens einem vorgegebenen Ladevorgang lädt oder die elektrische Batterie (6) in wenigstens einem vorgegebenen Entladevorgang entlädt
**dadurch gekennzeichnet, dass** das Diagnosetestgerät (2) ausgebildet ist wenigstens einen vorgegebenen Stromimpuls auf die elektrische Batterie (6) aufzubringen, während die elektrische Batterie (6) im Fahrzeug (4) verbaut ist;
von der Steuerelektronik (5) des Fahrzeugs (4) auf die Batterie (6) bezogene Daten zu empfangen; und
die von der Steuerelektronik (5) des Fahrzeugs (4) empfangenen Daten auszuwerten, um den Gesundheitszustand der Batterie (6) zu bestimmen.

2. Diagnosetestgerät (2) nach Anspruch 1, wobei die auf die Batterie (6) bezogenen Daten ein Belastungsprofil der Batterie (6) umfassen.

3. Diagnosetestgerät (2) nach Anspruch 1 oder 2, wobei das Diagnosetestgerät (2) ausgebildet ist, den Ladezustand nicht-defekter Module (61-65) der Batterie (6) zu bestimmen und den Ladezustand eines neu in die Batterie (6) einzubauenden Moduls (66) an den Ladezustand der nicht-defekten Module (61-65) der Batterie (6) anzupassen.

4. Diagnosetestgerät (2) nach einem der vorangehenden Ansprüche, wobei das Diagnosetestgerät (2) dazu ausgebildet ist, den Gesundheitszustand der Batterie (6) nach einer Reparatur, insbesondere nach einem Austausch wenigstens eines Moduls (61-66) der Batterie (6), zu bestimmen.

5. Diagnosetestgerät (2) nach einem der vorangehenden Ansprüche, wobei das Diagnosetestgerät (2) dazu ausgebildet ist, den Gesundheitszustand der Batterie (6) vor einer Reparatur zu bestimmen; wobei das Diagnosetestgerät (2) insbesondere dazu ausgebildet ist, den Gesundheitszustand einzelner Module (61-66) der Batterie (6) zu bestimmen.

6. Diagnosetestgerät (2) nach einem der vorangehenden Ansprüche, wobei das Diagnosetestgerät (2) dazu ausgebildet ist, die elektrische Lade-/Entladevorrichtung (12) derart anzusteuern, dass die elektrische Lade-/Entladevorrichtung (12) Tests an einer aus dem Fahrzeug (4) ausgebauten Batterie (6) vornimmt, wobei die Tests insbesondere umfassen, die elektrische Isolation der Batterie (6) und/oder die Niederohmigkeit der elektrischen Verbindungen mit und innerhalb der Batterie (6) zu testen.

7. Diagnosetestgerät (2) nach einem der vorangehenden Ansprüche, wobei das Diagnosetestgerät (2) dazu ausgebildet ist, drahtgebunden oder drahtlos mit der Steuerelektronik (5) des Fahrzeugs (4) und/oder mit der elektrischen Lade-/Entladevorrichtung (12) zu kommunizieren.

8. Diagnosetestgerät (2) nach einem der vorangehenden Ansprüche, wobei das Diagnosetestgerät (2) ausgebildet ist, die elektrische Lade-/Entladevorrichtung (12) so anzusteuern, dass sie elektrische Energie aus der Batterie (6) in eine elektrische Speichervorrichtung (15) und/oder in ein elektrisches Versorgungsnetz (14) einspeist.

9. Diagnoseplatz (1) für ein elektrisch betriebenes Fahrzeug (4) mit einer elektrischen Batterie (6), wobei der Diagnoseplatz (1) ein Diagnosetestgerät (2) nach einem der Ansprüche 1 bis 8 und eine elektrische Lade-/Entladevorrichtung (12) aufweist, die von dem Diagnosetestgerät (2) ansteuerbar ist.

10. Verfahren zum Bestimmen eines Gesundheitszustands einer in einem elektrisch betriebenen Fahrzeug (4) verbauten elektrischen Batterie (6), wobei das Verfahren umfasst,
das elektrisch betriebenen Fahrzeug (4) mit einer elektrischen Lade-/Entladevorrichtung (12) und mit einem Diagnosetestgerät (2), welches eine Eingabevorrichtung (24) und eine Ausgabevorrichtung (26) aufweist, zu verbinden;
die Lade-/Entladevorrichtung (12) mit dem Diagnosetestgerät (2) derart anzusteuern, dass die Lade-/Entladevorrichtung (12) die elektrische Batterie (6) in wenigstens einem vorgegebenen Ladevorgang lädt und/oder die elektrische Batterie (6) in wenigstens einem vorgegebenen Entladevorgang entlädt und wenigstens einen vorgegebenen Stromimpuls durch das Diagnosegerät (2) auf die elektrische Batterie (6) aufbringt;
während des wenigstens einen Lade- und/oder Entladevorgangs bzw. vor, während und/oder nach dem wenigstens einen vorgegebenen Stromimpuls auf die Batterie (6) bezogene Daten aufzunehmen; und
die auf die Batterie (6) bezogenen Daten auszuwerten, um den Gesundheitszustand der Batterie (6) zu bestimmen.

11. Verfahren zum Reparieren einer in einem elektrisch betriebenen Fahrzeug (4) verbauten elektrischen Batterie (6), wobei das Verfahren umfasst,
die elektrische Batterie (6) aus dem Fahrzeug (4) auszubauen;
die elektrische Batterie (6) zu reparieren, wobei das Reparieren insbesondere umfasst, wenigstens ein defektes Modul (61-65) und/oder wenigstens einen Modulverbinder (7) der elektrischen Batterie (6) auszutauschen;
die elektrische Batterie (6) wieder in das Fahrzeug (4) einzubauen; und
den Gesundheitszustand der wieder in das Fahrzeug (4) eingebauten Batterie (6) mit einem Verfahren nach Anspruch 10 zu bestimmen.

12. Verfahren nach Anspruch 11, wobei das Verfahren umfasst, den Gesundheitszustand der im Fahrzeug (4) verbauten Batterie (6) vor dem Ausbau der Batterie (6) mit einem Verfahren nach Anspruch 10 zu bestimmen; wobei das Verfahren insbesondere umfasst, defekte Module (61-65) der Batterie (6) zu identifizieren.

13. Verfahren nach Anspruch 11 oder 12, wobei das Verfahren umfasst, den Gesundheitszustand der Batterie (6) nach dem Austauschen wenigstens eines Moduls (61-66) und vor dem Einbauen der Batterie (6) in das Fahrzeug (4) zu bestimmen.

14. Verfahren nach einem der Ansprüche 11 bis 13, wobei das Verfahren umfasst, den Ladezustand nicht-defekter Module (61-65) der Batterie (6) zu bestimmen und den Ladezustand eines neu in die Batterie (6) einzubauenden Moduls an den Ladezustand der nicht-defekten Module (61-65) der Batterie (6) anzupassen.

15. Verfahren nach einem der Ansprüche 10 bis 14, wobei das Verfahren umfasst, elektrischen Energie aus einer elektrischen Speichervorrichtung (15) und/oder aus einem elektrischen Versorgungsnetz (14) zu entnehmen, um die Batterie (6) zu laden und/oder elektrischen Energie aus der Batterie (6) in die elektrische Speichervorrichtung (15) und/oder in das elektrische Versorgungsnetz (14) einzuspeisen.

## Claims

1. Diagnostic test device (2) for determining a state of health of an electrical battery (6) of an electrically driven vehicle (4),
wherein the diagnostic test device (2) has an input apparatus (24) and an output apparatus (26) and is able to be connected both to control electronics (5) of the vehicle (4) and to an electrical charging/discharging apparatus (12), and
wherein the diagnostic test device (2) is designed
to control the charging/discharging apparatus (12) in such a way that the charging/discharging apparatus (12) charges the electrical battery (6) in at least one predefined charging operation or discharges the electrical battery (6) in at least one predefined discharging operation,
**characterized in that** the diagnostic test device (2) is designed to apply at least one predefined current pulse to the electrical battery (6) while the electrical battery (6) is installed in the vehicle (4);
to receive data relating to the battery (6) from the control electronics (5) of the vehicle (4); and
to evaluate the data received from the control electronics (5) of the vehicle (4) in order to determine the state of health of the battery (6).

2. Diagnostic test device (2) according to Claim 1, wherein the data relating to the battery (6) comprise a load profile of the battery (6).

3. Diagnostic test device (2) according to Claim 1 or 2, wherein the diagnostic test device (2) is designed to determine the state of charge of non-defective modules (61-65) of the battery (6) and to adapt the state of charge of a module (66) that is to be newly installed in the battery (6) to the state of charge of the non-defective modules (61-65) of the battery (6).

4. Diagnostic test device (2) according to one of the preceding claims, wherein the diagnostic test device (2) is designed to determine the state of health of the battery (6) after a repair, in particular after at least one module (61-66) of the battery (6) has been replaced.

5. Diagnostic test device (2) according to one of the preceding claims, wherein the diagnostic test device (2) is designed to determine the state of health of the battery (6) before a repair; wherein the diagnostic test device (2) is in particular designed to determine the state of health of individual modules (61-66) of the battery (6).

6. Diagnostic test device (2) according to one of the preceding claims, wherein the diagnostic test device (2) is designed to control the electrical charging/discharging apparatus (12) in such a way that the electrical charging/discharging apparatus (12) performs tests on a battery (6) removed from the vehicle (4), wherein the tests in particular involve testing the electrical insulation of the battery (6) and/or the low impedance of the electrical connections to and within the battery (6).

7. Diagnostic test device (2) according to one of the preceding claims, wherein the diagnostic test device (2) is designed to communicate with the control electronics (5) of the vehicle (4) and/or with the electrical charging/discharging apparatus (12) in a wired or wireless manner.

8. Diagnostic test device (2) according to one of the preceding claims, wherein the diagnostic test device (2) is designed to control the electrical charging/discharging apparatus (12) such that it feeds electrical energy from the battery (6) into an electrical storage apparatus (15) and/or into an electrical supply network (14).

9. Diagnostic site (1) for an electrically driven vehicle (4) having an electrical battery (6), wherein the diagnostic site (1) has a diagnostic test device (2) according to one of Claims 1 to 8 and an electrical charging/discharging apparatus (12) which is able to be controlled by the diagnostic test device (2).

10. Method for determining a state of health of an electrical battery (6) installed in an electrically driven vehicle (4), wherein the method involves connecting the electrically driven vehicle (4) to an electrical charging/discharging apparatus (12) and to a diagnostic test device (2) which has an input apparatus (24) and an output apparatus (26);
controlling the charging/discharging apparatus (12) by means of the diagnostic test device (2) in such a way that the charging/discharging apparatus (12) charges the electrical battery (6) in at least one predefined charging operation and/or discharges the electrical battery (6) in at least one predefined discharging operation and applies by way of the diagnostic device (2) at least one predefined current pulse to the electrical battery (6);
receiving data relating to the battery (6) before, during and/or after the at least one predefined current pulse, respectively, during the at least one charging and/or discharging operation; and
evaluating the data relating to the battery (6) in order to determine the state of health of the battery (6).

11. Method for repairing an electrical battery (6) installed in an electrically driven vehicle (4), wherein the method involves
removing the electrical battery (6) from the vehicle (4);
repairing the electrical battery (6), wherein the repairing in particular involves replacing at least one defective module (61-65) and/or at least one module connector (7) of the electrical battery (6);
reinstalling the electrical battery (6) in the vehicle (4); and
determining by means of a method according to Claim 10 the state of health of the battery (6) that has been reinstalled in the vehicle (4).

12. Method according to Claim 11, wherein the method involves determining by means of a method according to Claim 10 the state of health of the battery (6) installed in the vehicle (4) before the battery (6) is removed; wherein the method in particular involves identifying defective modules (61-65) of the battery (6).

13. Method according to Claim 11 or 12, wherein the method involves determining the state of health of the battery (6) after at least one module (61-66) has been replaced and before the battery (6) has been installed in the vehicle (4).

14. Method according to one of Claims 11 to 13, wherein the method involves determining the state of charge of non-defective modules (61-65) of the battery (6) and adapting the state of charge of a module that is to be newly installed in the battery (6) to the state of charge of the non-defective modules (61-65) of the battery (6).

15. Method according to one of Claims 10 to 14, wherein the method involves drawing electrical energy from an electrical storage apparatus (15) and/or from an electrical supply network (14) in order to charge the battery (6) and/or feeding electrical energy from the battery (6) into the electrical storage apparatus (15) and/or into the electrical supply network (14).

## Revendications

1. Appareil de test de diagnostic (2) destiné à déterminer un état de santé d'une batterie électrique (6) d'un véhicule à propulsion électrique (4),
l'appareil de test de diagnostic (2) possédant un dispositif d'entrée (24) et un dispositif de sortie (26) et pouvant être relié aussi bien à une électronique de commande (5) du véhicule (4) qu'à un dispositif de charge/décharge électrique (12), et
l'appareil de test de diagnostic (2) étant configuré pour commander le dispositif de charge/décharge (12) de telle sorte que le dispositif de charge/décharge (12) charge la batterie électrique (6) au cours d'au moins une opération de charge prédéfinie ou décharge la batterie électrique (6) au cours d'au moins une opération de décharge prédéfinie **caractérisé en ce que** l'appareil de test de diagnostic (2) est configuré pour appliquer au moins une impulsion de courant prédéfinie à la batterie électrique (6) pendant que la batterie électrique (6) est installée dans le véhicule (4) ;
recevoir des données relatives à la batterie (6) en provenance de l'électronique de commande (5) du véhicule (4) ; et
interpréter les données reçues de l'électronique de commande (5) du véhicule (4) afin de déterminer l'état de santé de la batterie (6).

2. Appareil de test de diagnostic (2) selon la revendication 1, les données relatives à la batterie (6) comprenant un profil de sollicitation de la batterie (6).

3. Appareil de test de diagnostic (2) selon la revendication 1 ou 2, l'appareil de test de diagnostic (2) étant configuré pour déterminer l'état de charge de modules non défectueux (61-65) de la batterie (6) et pour adapter l'état de charge d'un nouveau module (66) à monter dans la batterie (6) à l'état de charge des modules non défectueux (61-65) de la batterie (6).

4. Appareil de test de diagnostic (2) selon l'une des revendications précédentes, l'appareil de test de diagnostic (2) étant configuré pour déterminer l'état de santé de la batterie (6) après une réparation, notamment après un remplacement d'au moins un module (61-66) de la batterie (6).

5. Appareil de test de diagnostic (2) selon l'une des revendications précédentes, l'appareil de test de diagnostic (2) étant configuré pour déterminer l'état de santé de la batterie (6) avant une réparation ; l'appareil de test de diagnostic (2) étant notamment configuré pour déterminer l'état de santé de modules (61-66) individuels de la batterie (6).

6. Appareil de test de diagnostic (2) selon l'une des revendications précédentes, l'appareil de test de diagnostic (2) étant configuré pour commander le dispositif de charge/décharge électrique (12) de telle sorte que le dispositif de charge/décharge électrique (12) effectue des tests sur une batterie (6) démontée du véhicule (4), les tests comprenant notamment le fait de tester l'isolation électrique de la batterie (6) et/ou la basse impédance des connexions électriques avec et à l'intérieur de la batterie (6).

7. Appareil de test de diagnostic (2) selon l'une des revendications précédentes, l'appareil de test de diagnostic (2) étant configuré pour communiquer, de manière filaire ou sans fil, avec l'électronique de commande (5) du véhicule (4) et/ou avec le dispositif de charge/décharge électrique (12).

8. Appareil de test de diagnostic (2) selon l'une des revendications précédentes, l'appareil de test de diagnostic (2) étant configuré pour commander le dispositif de charge/décharge électrique (12) de telle sorte qu'il injecte de l'énergie électrique provenant de la batterie (6) dans un dispositif de stockage électrique (15) et/ou dans un réseau d'alimentation électrique (14).

9. Poste de diagnostic (1) pour un véhicule à propulsion électrique (4) comprenant une batterie électrique (6), le poste de diagnostic (1) possédant un appareil de test de diagnostic (2) selon l'une des revendications 1 à 8 et un dispositif de charge/décharge électrique (12) qui peut être commandé par l'appareil de test de diagnostic (2).

10. Procédé de détermination d'un état de santé d'une batterie électrique (6) installée dans un véhicule à propulsion électrique (4), le procédé comprenant, relier le véhicule à propulsion électrique (4) à un dispositif de charge/décharge électrique (12) et à un appareil de test de diagnostic (2), lequel possède un dispositif d'entrée (24) et un dispositif de sortie (26) ;
commander le dispositif de charge/décharge (12) avec l'appareil de test de diagnostic (2) de telle sorte que le dispositif de charge/décharge (12) charge la batterie électrique (6) dans au moins une opération de charge prédéfinie et/ou décharge la batterie électrique (6) dans au moins une opération de décharge prédéfinie et applique à la batterie électrique (6) au moins une impulsion de courant prédéfinie par l'appareil de diagnostic (2) ;
enregistrer des données relatives à la batterie (6) pendant l'au moins une opération de charge et/ou de décharge ou avant, pendant et/ou après l'au moins une impulsion de courant prédéterminée ; et
interpréter les données relatives à la batterie (6) afin de déterminer l'état de santé de la batterie (6).

11. Procédé de réparation d'une batterie électrique (6) installée dans un véhicule à propulsion électrique (4), le procédé comprenant,
démonter la batterie électrique (6) du véhicule (4) ;
réparer la batterie électrique (6), la réparation comprenant notamment le remplacement d'au moins un module (61-65) et/ou d'au moins un connecteur de module (7) défectueux de la batterie électrique (6) ;
réinstaller la batterie électrique (6) dans le véhicule (4) ; et
déterminer l'état de santé de la batterie (6) réinstallée dans le véhicule (4) avec un procédé selon la revendication 10.

12. Procédé selon la revendication 11, le procédé comprenant la détermination de l'état de santé de la batterie (6) installée dans le véhicule (4) avant le démontage de la batterie (6) avec un procédé selon la revendication 10 ; le procédé comprenant notamment l'identification de modules (61-65) défectueux de la batterie (6).

13. Procédé selon la revendication 11 ou 12, le procédé comprenant la détermination de l'état de santé de la batterie (6) après le remplacement d'au moins un module (61-66) et avant l'installation de la batterie (6) dans le véhicule (4).

14. Procédé selon l'une des revendications 11 à 13, le procédé comprenant la détermination de l'état de charge de modules (61-65) non défectueux de la batterie (6) et l'adaptation de l'état de charge d'un nouveau module à installer dans la batterie (6) à l'état de charge des modules (61-65) non défectueux de la batterie (6).

15. Procédé selon l'une des revendications 10 à 14, le procédé comprenant le prélèvement d'énergie électrique d'un dispositif de stockage électrique (15) et/ou d'un réseau d'alimentation électrique (14) afin de charger la batterie (6) et/ou l'injection d'énergie électrique de la batterie (6) dans le dispositif de stockage électrique (15) et/ou dans le réseau d'alimentation électrique (14).
